# EUROPEAN PATENT APPLICATION

(11) **EP 4 492 435 A1**
(43) Date of publication of application: **15.01.2025**
(21) Application number: 23766429.7
(22) Date of filing: 13.02.2023
(51) Int. Cl.: H01L 21/60, H01L 21/50, H01L 21/677

(54) **CHIP BONDING APPARATUS, CHIP PROCESSING SYSTEM, AND CHIP PROCESSING METHOD**

(30) Priority: 11.03.2022 JP 2022038103
(71) Applicant: Tokyo Electron Limited, Tokyo 107-6325 (JP)
(72) Inventor: MIZOMOTO, Yasutaka, Kikuchi-gun, Kumamoto 869-1232 (JP); HAYAKAWA, Susumu, Kikuchi-gun, Kumamoto 869-1232 (JP)
(74) Representative: Manitz Finsterwald Patent- und Rechtsanwaltspartnerschaft mbB
(86) International application number: PCT/JP2023/004765
(87) International publication number: WO 2023/171249

(57) **Abstract**

A chip attaching device is configured to attach a chip having a second device to a device substrate having multiple first devices on a main surface thereof, and the second device is to be electrically connected to the first device. The chip attaching device includes a first carrier holder, a substrate holder, a pickup device and a mounting device. The first carrier holder is configured to hold a chip carrier which has, on a front surface thereof, multiple attraction portions, the attraction portion being configured to electrostatically attract the chip. The substrate holder is configured to hold the device substrate. The pickup device is configured to separate the chip from the chip carrier held by the first carrier holder. The mounting device is configured to mount the chip separated from the chip carrier by the pickup device on the device substrate held by the substrate holder.

## Description

### TECHNICAL FIELD

The various aspects and embodiments described herein pertain generally to a chip attaching device, a chip processing system, and a chip processing method.

### BACKGROUND

A substrate carrier described in Patent Document 1 includes a doped semiconductor substrate, a plurality of electrostatic field generating circuits that generate an electrostatic field, and a charging interface. Each electrostatic field generating circuit has a positive electrode, a negative electrode, and a bias electrode. The charging interface turns each electrostatic field on or off by charging or discharging the electrostatic field generating circuit.

A substrate carrier described in Patent Document 2 is equipped with an electrical insulating layer and an electrode embedded inside the electrical insulating layer. A part of the electrode is exposed on a rear surface of the substrate carrier and functions as a connection terminal connected to each switch of a voltage controller.

### PRIOR ART DOCUMENT

Patent Document 1: US Patent No. 9984913.
Patent Document 2: Japanese Patent Laid-open Publication No. 2009-099674

### DISCLOSURE OF THE INVENTION

### PROBLEMS TO BE SOLVED BY THE INVENTION

Exemplary embodiments provide a technique capable of improving the workability of a work of transferring a chip from a carrier to a device substrate.

### MEANS FOR SOLVING THE PROBLEMS

In an exemplary embodiment, a chip attaching device is configured to attach a chip having a second device to a device substrate having multiple first devices on a main surface thereof, and the second device is to be electrically connected to the first device. The chip attaching device includes a first carrier holder, a substrate holder, a pickup device and a mounting device. The first carrier holder is configured to hold a chip carrier which has, on a front surface thereof, multiple attraction portions, the attraction portion being configured to electrostatically attract the chip. The substrate holder is configured to hold the device substrate. The pickup device is configured to separate the chip from the chip carrier held by the first carrier holder. The mounting device is configured to mount the chip separated from the chip carrier by the pickup device on the device substrate held by the substrate holder.

### EFFECT OF THE INVENTION

According to the exemplary embodiment, it is possible to improve the workability of a work of transferring a chip from a carrier to a device substrate.

### BRIEF DESCRIPTION OF THE DRAWINGS

**FIG.** 1 is a plan view illustrating an example of a second chip processing system.
**FIG.** 2A is a cross sectional view illustrating an example of chips mounted on a frame with a tape therebetween, **FIG. 2B** is a cross sectional view illustrating an example of a chip carrier, and **FIG. 2C** is a cross sectional view illustrating an example of the chips electrostatically attracted to the chip carrier.
**FIG.** 3 is a plan view illustrating an example of attraction portions and recesses in a front surface of a carrier substrate.
**FIG.** 4 is a plan view illustrating a modification example of the attraction portions and the recesses in the surface of the carrier substrate.
**FIG. 5** is a cross sectional view illustrating a chip array device.
**FIG. 6** is a plan view illustrating an example of a first chip processing system.
**FIG. 7A** is a cross sectional view illustrating an example of a device substrate, **FIG. 7B** is a cross sectional view showing an example of chips from which a protective film is removed, and **FIG. 7C** is a cross sectional view illustrating an example of the device substrate with the chips attached thereto.
**FIG. 8** is a cross sectional view illustrating an example of a chip cleaning device.
**FIG. 9** is a cross sectional view illustrating an example of a chip attaching device.
**FIG. 10** is a cross sectional view illustrating an example of a gas supply line.
**FIG. 11A** is a cross sectional view illustrating an example of an operation of a first contact position adjuster, **FIG. 11B** is a cross sectional view illustrating an example of an operation following that of **FIG. 11A,** and **FIG. 11C** is a cross sectional view illustrating an example of an operation following that of **FIG. 11B****.**
**FIG. 12** is a cross sectional view illustrating a modification example of the chip attaching device.
**FIG. 13** is a cross sectional view illustrating a modification example of the chip carrier.

### DETAILED DESCRIPTION

Hereinafter, exemplary embodiments of the present disclosure will be described with reference to the accompanying drawings, which form a part hereof. In the various drawings, same or corresponding parts will be assigned same or corresponding reference numerals, and redundant descriptions thereof will be omitted. In the present specification, the X-axis direction, the Y-axis direction, and the Z-axis direction are orthogonal to each other. The X-axis direction and the Y-axis directions are horizontal directions, whereas the Z-axis direction is a vertical direction.

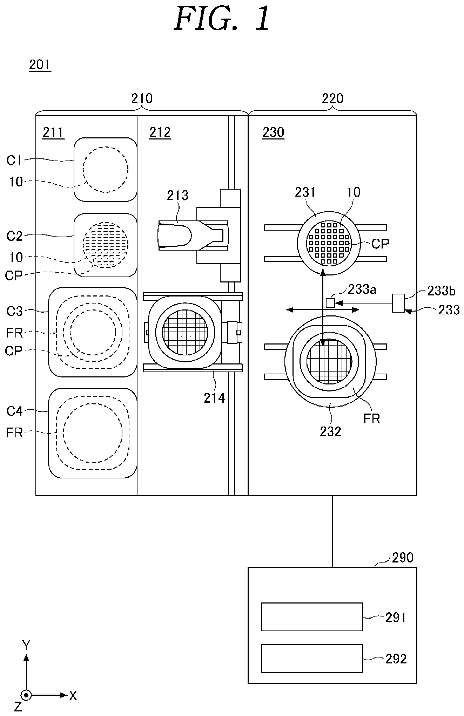

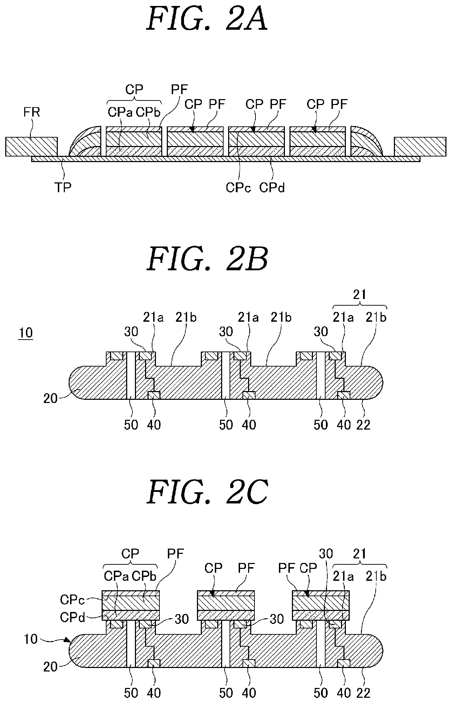

Referring to **FIG. 1** to **FIG. 5****,** an example of a second chip processing system 201 will be described. As shown in **FIG. 2A** to **FIG. 2C****,** the second chip processing system 201 is configured to transfer chips CP, which are mounted on a frame FR with a tape TP therebetween, from the tape TP to a chip carrier 10, thereby rearranging the chips CP.

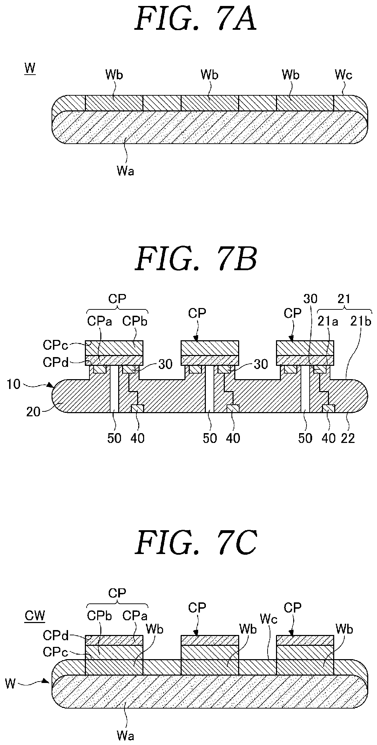

A processing performed by the second chip processing system 201 is performed before a processing by a first chip processing system 101 to be described later. The first chip processing system 101 mounts the chips CP on a device substrate W. As a result, first devices Wb of the device substrate W and second devices CPb of the chips CP are electrically connected (see **FIG. 7C**).

Although the first chip processing system 101 and the second chip processing system 201 are provided separately in the present exemplary embodiment, they may be integrated. For example, a chip array device 230 of the second chip processing system 201 may be mounted in the first chip processing system 101.

The plurality of chips CP as shown in **FIG. 2A** are carried into the second chip processing system 201. The plurality of chips CP are attached to the tape TP, and an outer periphery of the tape TP is mounted to the frame FR. The plurality of chips CP are arranged in an opening of the frame FR. These chips CP are obtained by dicing a substrate, that is, by splitting the substrate into individual pieces.

The chip CP has a base substrate CPa and the second device CPb formed on the base substrate CPa. The base substrate CPa is, for example, a silicon wafer, a compound semiconductor wafer, or a glass substrate. The second device CPb includes a semiconductor element, a circuit, a terminal, or the like. The second device CPb is disposed on the opposite side of the tape TP with the base substrate CPa therebetween.

The second device CPb is covered with a protective film PF before the substrate is diced. The protective film PF protects the second device CPb when the substrate is diced, for example. The protective film PF is split into individual pieces together with the substrate. The protective film PF is not particularly limited, but it is desirably water-soluble. After the dicing, by supplying pure water or the like to the water-soluble protective film PF, the protective film PF may be removed.

The chip carrier 10 as shown in **FIG. 2B** is carried into the second chip processing system 201. The chip carrier 10 electrostatically attracts the plurality of chips CP and transfers them. The plurality of chips CP are transported together with the chip carrier 10. The chip carrier 10 is equipped with a carrier substrate 20, a plurality of electrodes 30, and a plurality of operation terminals 40.

The carrier substrate 20 has a front surface 21 and a rear surface 22 opposite to the front surface 21. The front surface 21 of the carrier substrate 20 has a plurality of attraction portions 21a configured to come into contact with the chips CP and electrostatically attract the chips CP. The carrier substrate 20 serves to insulate the plurality of electrodes 30 and maintain electric charges supplied to each electrode 30.

The carrier substrate 20 may be provided with a non-illustrated capacitor. The capacitor accumulates the electric charges to be supplied to each electrode 30. The electric charges may be either positive charges or negative charges. Also, the capacitor may recover the electric charges discharged from each electrode 30. The capacitor is electrically connected to each electrode 30 via, for example, the corresponding operation terminal 40.

In addition, the electric charges may be supplied to each electrode 30 from the outside of the carrier substrate 20. Also, the electric charges may be discharged from each electrode 30 to the outside of the carrier substrate 20.

The plurality of electrodes 30 are provided in the carrier substrate 20 and configured to individually generate an attracting force for electrostatically attracting the chip CP on each of the attraction portions 21a. The electrode 30 is provided for each attraction portion 21a. The electrode 30 may be of either a unipolar type or a bipolar type. Although the electrode 30 is exposed on the front surface 21 of the carrier substrate 20, it does not need to be exposed and may be embedded inside the carrier substrate 20.

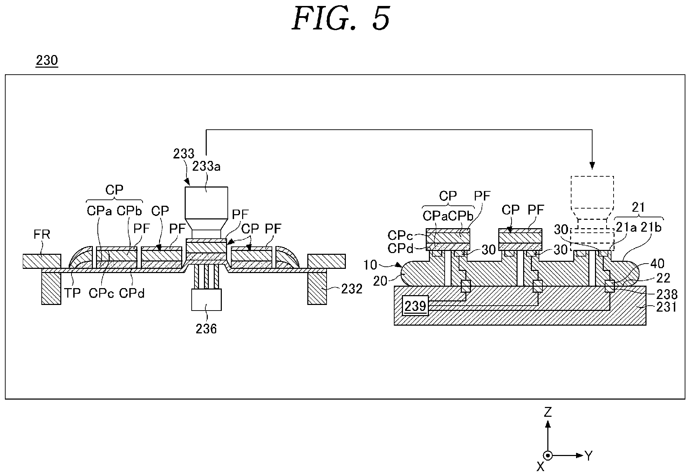

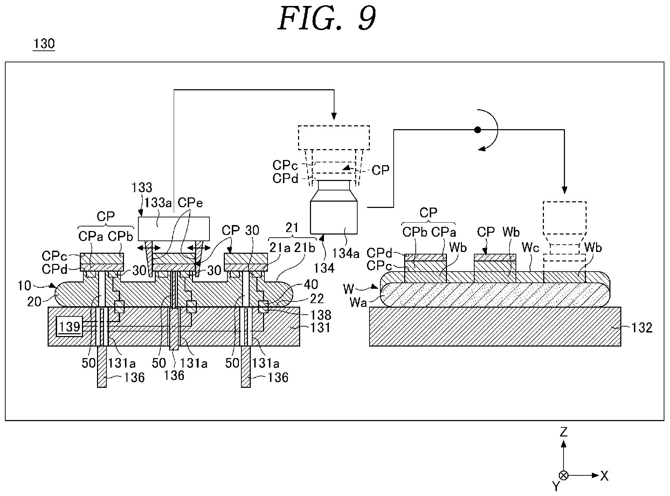

The operation terminals 40 are provided in the carrier substrate 20, and are connected to a second attracting force controller 239 (see FIG. 5) or a first attracting force controller 139 (see **FIG. 9****,** **FIG. 10****,** **FIG. 11A** to **FIG. 11C****,** and **FIG. 12**), and receives a control signal from the second attracting force controller 239 or the first attracting force controller 139. Hereinafter, the first attracting force controller 139 and the second attracting force controller 239 may be collectively referred to as attracting force controllers 139 and 239.

The attracting force controllers 139 and 239 control the attracting force by controlling the electric charges accumulated in the electrode 30. For example, the attracting force controllers 139 and 239 control generation or dissipation of the attracting force by controlling the supply/discharge of the electric charges to/from the electrode 30. The attracting force is a Coulomb force or a Johnson-Rahbek force.

As the electric charges are accumulated in the electrode 30, the attracting force is generated. Afterwards, even after the connection between the operation terminal 40 and the second attracting force controller 239 is released, the operation terminal 40 maintains the state in which the electric charges are accumulated in the electrode 30, thereby maintaining the state in which the attracting force is generated. Accordingly, the plurality of chips CP can be transferred together with the chip carrier 10.

As the electric charges are discharged from the electrode 30, the attracting force disappears, which enables the chips CP to be separated from the chip carrier 10 afterwards. Since the generation and the dissipation of the attracting force are controlled by controlling the supply and the discharge of the electric charges, the workability of the work of moving the chips CP can be improved as compared to a case of applying and removing an adhesive.

The operation terminal 40 is exposed on the rear surface 22 of the carrier substrate 20, and is connected to the attracting force controllers 139 and 239 by wire. Alternatively, the operation terminal 40 and the attracting force controllers 139 and 239 may be connected wirelessly. In addition, the operation terminal 40 may be exposed on the front surface 21 or a side surface of the carrier substrate 20.

The operation terminal 40 is provided for each of the attraction portions 21a individually. Alternatively, one operation terminal 40 may be shared by the plurality of attraction portions 21a. In any case, the attracting force controllers 139 and 239 only need to control the attracting force for each of the attraction portions 21a individually.

However, the front surface 21 of the carrier substrate 20 has a recess 21b at a periphery of each of the plurality of attraction portions 21a, and the recess 21b is recessed more than the attraction portions 21a. With this configuration, as will be described in detail later, a side surface CPe of the chip CP can be held along the entire vertical direction thereof by a side holding head 133a inserted into the recess 21b, as shown in **FIG. 9****.** Accordingly, the side surface CPe of the chip CP can be stably held, so the chip CP can be suppressed from falling down. Furthermore, a bottom surface (second surface CPd) of the chip CP as well as the side surface CPe thereof may be supported.

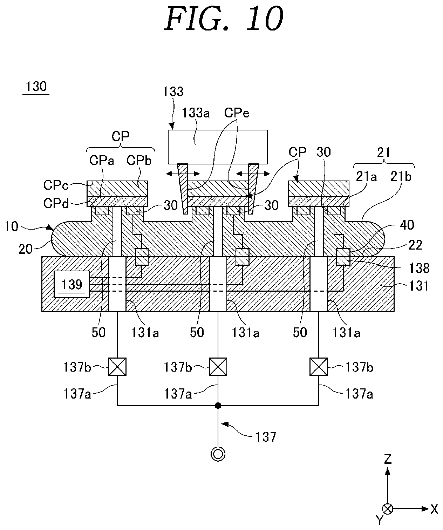

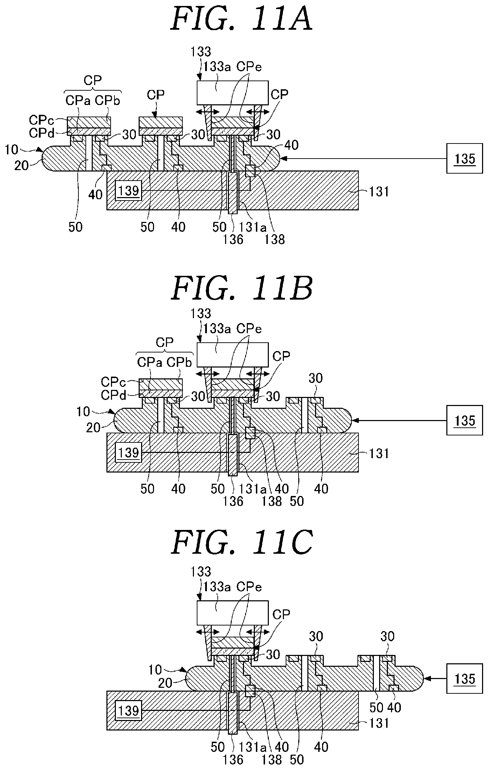

The chip carrier 10 may be provided with, in the attraction portion 21a, a through hole 50 formed through the carrier substrate 20 from the front surface 21 to the rear surface 22 thereof. As a result, as will described in detail later, by inserting a push pin 136 into the through hole 50 and pressing the chip CP with the push pin 136 as shown in **FIG. 9** or **FIG. 11A** to **FIG. 11C****,** the separation of the chip CP can be assisted. Alternatively, as shown in **FIG. 10****,** by supplying a gas from a gas supply line 137 into the through hole 50 and pressing the chip CP with the pressure of the gas, the separation of the chip CP can be assisted.

The electrode 30 may be disposed to surround the through hole 50. One electrode 30 may be disposed in a ring shape around the through hole 50, or a multiple number of electrodes 30 may be arranged around the through hole 50 at a certain distance therebetween. The number of the electrodes 30 may be three or more. As the electrode(s) 30 is (are) disposed to surround the through hole 50, the chip CP can be electrostatically attracted to the attraction portion 21a stably.

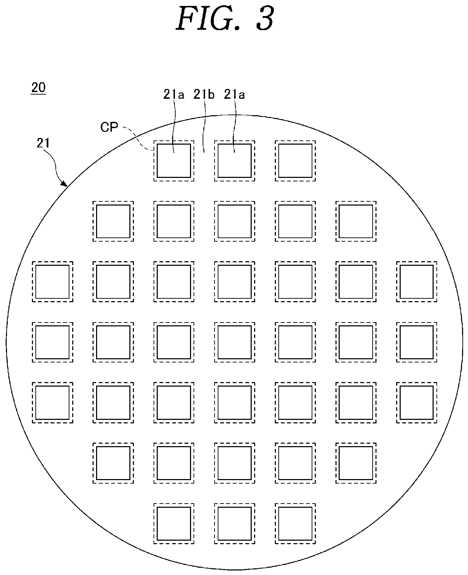

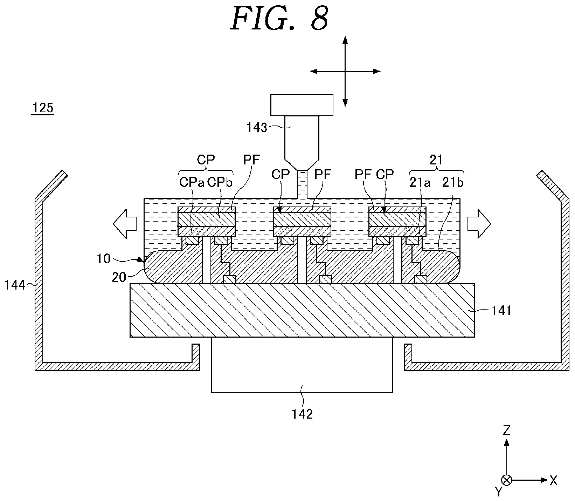

As shown in **FIG. 3****,** the recess 21b is formed in a net shape, and the attraction portions 21a may be arranged in an island shape in the meshes of the recess 21b. With this configuration, when supplying a cleaning liquid to the chip CP for the purpose of, for example, removing the protective film PF as illustrated in **FIG. 8****,** the cleaning liquid can be easily discharged from the recess 21b, which will be described in detail later.

The recess 21b extends up to an edge of the front surface 21 of the carrier substrate 20 so as to facilitate the discharge of the cleaning liquid to the outside of the carrier substrate 20. The depth of the recess 21b is uniform in overall, but the recess 21b may become deeper as it goes from the center of the front surface 21 of the carrier substrate 20 toward the edge thereof. In the latter case, the cleaning liquid can be discharged by using gravity.

The attraction portion 21a may be smaller than the chip CP. As compared to a case where the attraction portion 21a has the same size as the chip CP, the required level of positioning accuracy for the chips CP may be somewhat reduced when rearranging the plurality of chips CP on the chip carrier 10. If the attraction portion 21a is smaller than the chip CP, even if the chip CP is slightly misaligned, the chip CP sticks out from the attraction portion 21a. Therefore, the side surface CPe of the chip CP may be held along the entire vertical direction thereof.

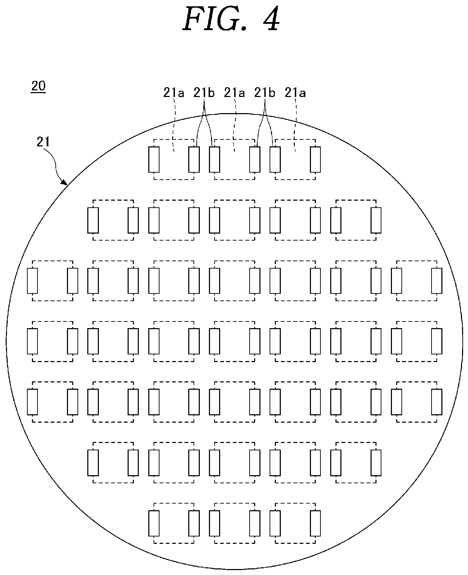

Although the recess 21b may be formed along the entire periphery of the attraction portion 21a as shown in **FIG. 3****,** it may be formed at a part of the periphery of the attraction portion 21a as shown in **FIG. 4****.** Even in the latter case, the side surface CPe of the chip CP can be held along the entire vertical direction thereof by the side holding head 133a inserted into the recess 21b, so that the side surface CPe of the chip CP can be held stably.

As depicted in **FIG. 1****,** the second chip processing system 201 is equipped with, for example, a second carry-in/out station 210, a second processing station 220, and a second control device 290. The second carry-in/out station 210 and the second processing position 220 are arranged in this order from the negative X-axis side toward the positive X-axis side.

The second carry-in/out station 210 has a placement table 211. Cassettes C1 to C4 are placed on the placement table 211. The cassette C1 accommodates the chip carrier 10. The cassette C2 accommodates the chip carrier 10 with the plurality of chips CP electrostatically attached thereto. The cassette C3 accommodates the plurality of chips CP mounted on the frame FR with the tape TP therebetween. The cassette C4 accommodates the used frame FR. Here, the used frame FR means the frame FR left after the plurality of chips CP are separated from the tape TP. The chips CP may remain at the used frame FR.

The second carry-in/out station 210 has a third transfer section 212, a third carrier transfer arm 213, and a frame transfer arm 214. The third transfer section 212 is adjacent to the placement table 211. The third carrier transfer arm 213 is configured to hold and transfer the chip carrier 10 in the third transfer section 212. The frame transfer arm 214 is configured to hold and transfer the frame FR in the third transfer section 212. Each of the third carrier transfer arm 213 and the frame transfer arm 214 is configured to be movable in a horizontal direction (both in the X-axis direction and the Y-axis direction) and a vertical direction, and pivotable around a vertical axis.

The second carry-in/out station 210 has a non-illustrated driver configured to move or rotate the third carrier transfer arm 213 and the frame transfer arm 214. The third carrier transfer arm 213 and the frame transfer arm 214 may be mounted on the same Y-axis slider and simultaneously moved in the Y-axis direction, or may be mounted on different Y-axis sliders and independently moved in the Y-axis direction. When the third carrier transfer arm 213 and the frame transfer arm 214 are mounted on the same Y-axis slider, they may be stacked on top of each other in the Z-axis direction. When the third carrier transfer arm 213 and the frame transfer arm 214 are mounted on different Y-axis sliders, on the other hand, the Y-axis sliders are arranged with an offset in the Z-axis direction.

The third carrier transfer arm 213 takes out the chip carrier 10 from the cassette C1, and transfers it to the chip array device 230. Further, the third carrier transfer arm 213 takes out the chip carrier 10 having the plurality of chips CP electrostatically attracted thereto from the chip array device 230, and stores it in the cassette C2. The third carrier transfer arm 213 that takes out the chip carrier 10 from the cassette C1 and the third carrier transfer arm 213 that stores the chip carrier 10 in the cassette C2 may be provided separately.

The frame transfer arm 214 takes out the plurality of chips CP together with the frame FR from the cassette C3, and transfers them to the chip array device 230. Also, the frame transfer arm 214 takes out the used frame FR from the chip array device 230, and stores it in the cassette C4. The frame transfer arm 214 that takes out the frame FR from the cassette C3 and the frame transfer arm 214 that stores the frame FR in the cassette C4 may be provided separately.

The second processing station 220 is equipped with the chip array device 230. The chip array device 230 is adjacent to the third transfer section 212. The chip array device 230 moves the chips CP mounted on the frame FR with the tape TP therebetween from the tape TP to the chip carrier 10, thus rearranging the chips CP. The chip array device 230 is equipped with, for example, a second carrier holder 231, a frame holder 232, and a chip transferer 233, as shown in **FIG. 5****.**

The second carrier holder 231 is configured to hold the chip carrier 10. The second carrier holder 231 holds the carrier substrate 20 horizontally from below, allowing the front surface 21 of the carrier substrate 20 to face upwards, for example. The second carrier holder 231 is configured to be movable in a horizontal direction (both in the X-axis direction and the Y-axis direction or only in the X-axis direction), and rotatable around a vertical axis.

The frame holder 232 is configured to hold the frame FR on which the plurality of chips CP are mounted with the tape TP therebetween. The frame holder 232 holds the frame FR horizontally from below, for example. The frame holder 232 is configured to be movable in a horizontal direction (both in the X-axis direction and the Y-axis direction or only in the X-axis direction), and rotatable around a vertical axis.

The chip transferer 233 is configured to transfer the chip CP from the tape TP provided in the opening of the frame FR held by the frame holder 232 to the chip carrier 10 held by the second carrier holder 231. The chip transferer 233 has a collet 233a configured to hold the chip CP, and a collet moving mechanism 233b (see **FIG. 1**) configured to move the collet 233a. The collet 233a is configured to vacuum-attract the chip CP. The collet 233a is configured to be movable in a horizontal direction (both in the X-axis direction and the Y-axis direction) and a vertical direction, and rotatable around a vertical axis.

The collet 233a holds the chip CP from the opposite side to the tape TP. The chip CP has a first surface CPc, and a second surface CPd that is in contact with the tape TP in the opposite direction to the first surface CPc. The protective film PF is formed on the first surface CPc in advance, and the collet 233a holds the chip CP with the protective film PF interposed therebetween. As a result, contact between the chip CP and the collet 233a can be suppressed, so that the chip CP can be suppressed from having a contact scratch. This is particularly effective when the first surface CPc of the chip CP includes the second device CPb.

With the collet 233a holding the chip CP from above, the collet moving mechanism 233b moves the collet 233a upwards, allowing the chip CP to be separated from the tape TP. Thereafter, the collet moving mechanism 233b moves the collet 233a horizontally and then downwards, allowing the chip CP to be mounted on the chip carrier 10.

The chip CP is mounted on the chip carrier 10 without being turned upside down. The second surface CPd of the chip CP comes into contact with the attraction portion 21a of the front surface 21 of the carrier substrate 20. The attraction portion 21a may be smaller than the second surface CPd of the chip CP, and the second surface CPd of the chip CP may stick out from the attraction portion 21a.

The chip array device 230 may have a push pin 236. The push pin 236 pushes the chip CP up from below via the tape TP. The collet 233a attracts the chip CP pushed up by the push pin 236. By pushing the chip CP to be separated up to be higher than the neighboring chips CP, contact between the neighboring chips CP and the collet 233a can be suppressed.

The chip array device 230 may have an expander, although not shown. The expander expands the tape TP in a radial shape, thus increasing an interval between the neighboring chips CP. As a result, it is possible to suppress the neighboring chips CP from being rubbed against each other.

The second carrier holder 231 is provided with, for example, a second contact terminal 238 and a second attracting force controller 239. The second contact terminal 238 comes into contact with the operation terminal 40 of the chip carrier 10. A plurality of second contact terminals 238 are provided in correspondence to the plurality of operation terminals 40. The second attracting force controller 239 is connected to the operation terminal 40 of the chip carrier 10 via the corresponding second contact terminal 238 provided in the second carrier holder 231. The operation terminal 40 receives a control signal transmitted from the second attracting force controller 239. Further, the second attracting force controller 239 may be provided outside the second carrier holder 231 or may be a part of the second control device 290.

The second attracting force controller 239 controls the attracting force in the state that it is connected to the operation terminal 40 of the chip carrier 10. The second attracting force controller 239 controls the electric charges accumulated in the electrode 30. The second attracting force controller 239 performs a control of supplying the electric charges to the electrode 30 to implement a control of generating the attracting force. The timing for supplying the electric charges to the electrode 30 may be different between the attraction portions 21a or may be the same between the attraction portions 21a.

Even if the connection between the operation terminal 40 and the second attracting force controller 239 is released after the chip array device 230 moves the chip CP from the tape TP to the chip carrier 10, the operation terminal 40 maintains the state in which the electric charges are accumulated in the electrode 30, thus maintaining the state in which the attracting force is generated. Accordingly, the plurality of chips CP can be transferred together with the chip carrier 10.

The second control device 290 is, for example, a computer, and has a CPU (Central Processing Unit) 291 and a recording medium 292 such as a memory. The recording medium 292 stores a program that controls various processes performed in the second chip processing system 201. The second control device 290 controls the operation of the second chip processing system 201 by causing the CPU 291 to execute the program stored in the recording medium 292. A module controller that controls an operation of each of modules constituting the second chip processing system 201 may be provided, and a system controller that comprehensively controls the plurality of module controllers may be provided. The module controllers and the system controller may constitute the second control device 290.

Next, an example of a chip processing method using the second chip processing system 201 will be described. The following chip processing method is performed under the control of the second control device 290.

First, the third carrier transfer arm 213 of the second carry-in/out station 210 takes out the chip carrier 10 from the cassette C1, and transfers it to the chip array device 230. Once the second carrier holder 231 of the chip array device 230 holds the chip carrier 10, the third carrier transfer arm 213 is retreated from the chip array device 230.

Further, the frame transfer arm 214 of the second carry-in/out station 210 takes out the plurality of chips CP from the cassette C3 together with the frame FR, and transfers them to the chip array device 230. Once the frame holder 232 of the chip array device 230 holds the frame FR, the frame transfer arm 214 is retreated from the chip array device 230.

Next, the chip array device 230 moves the chips mounted on the frame FR via the tape TP from the tape TP to the chip carrier 10, thus rearranging the chips CP. The chip carrier 10 electrostatically attracts the plurality of chips CP.

Then, the third carrier transfer arm 213 takes out the chip carrier 10 with the plurality of chips CP electrostatically attracted thereto from the chip array device 230, and stores it in the cassette C2. Afterwards, the plurality of chips CP are provided to the first chip processing system 101 in the state that they are electrostatically attracted to the chip carrier 10.

Further, the frame transfer arm 214 takes out the used frame FR from the chip array device 230, and stores it in the cassette C4. The frame FR is reused.

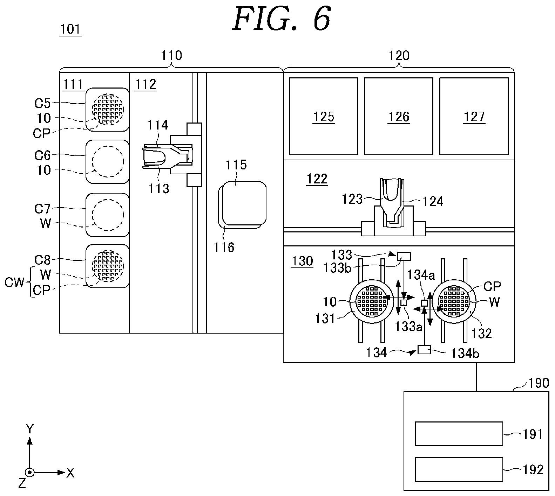

Referring to **FIG. 6** to **FIG. 10****,** an example of the first chip processing system 101 will be described. As shown in **FIG. 7A** to **FIG. 7C****,** the first chip processing system 101 separates the chips CP from the chip carrier 10 and mounts the separated chips CP on the device substrate W, thereby manufacturing a chip-attached substrate CW.

The device substrate W shown in **FIG. 7A** is carried into the first chip processing system 101. The device substrate W has a base substrate Wa and a plurality of first devices Wb formed on the base substrate Wa. The base substrate Wa is, for example, a silicon wafer, a compound semiconductor wafer, or a glass substrate. The first device Wb includes a semiconductor element, a circuit, a terminal, or the like. The plurality of first devices Wb are formed on a main surface Wc of the device substrate W.

Although the chip carrier 10 shown in **FIG. 7B** may be carried into the first chip processing system 101, the chip carrier 10 shown in **FIG. 2B** is carried in in the present exemplary embodiment. The chip carrier 10 has the plurality of chips CP electrostatically attracted thereto. The chip CP has, on the first surface CPc thereof, the second device CPb electrically connected to the first device Wb.

The first surface CPc of the chip CP does not have to be covered with the protective film PF, as shown in **FIG. 7B** when it is carried in. In the present exemplary embodiment, however, it is covered with the protective film PF, as shown in **FIG. 2B****.** The protective film PF may protect the first surface CPc of the chip CP until just before the chip CP is mounted, so that adhesion of particles and formation of scratches may be suppressed.

As illustrated in **FIG. 6****,** the first chip processing system 101 includes, by way of example, a first carry-in/out station 110, a first processing station 120, and a first control device 190. The first carry-in/out station 110 and the first processing station 120 are arranged in this order from the negative X-axis side toward the positive X-axis side.

The first carry-in/out station 110 is equipped with a placement table 111. Cassettes C5 to C8 are placed on the placement table 111. The cassette C5 accommodates the chip carrier 10 from which the chips CP are yet to be separated. The cassette C6 accommodates the chip carrier 10 from which the chips CP have been separated. The cassette C7 accommodates the device substrate W before being mounted with the chips CP. The cassette C8 accommodates the device substrate W on which the chips CP are mounted.

The first carry-in/out station 110 has a second transfer section 112, a second carrier transfer arm 113, and a second substrate transfer arm 114. The second transfer section 112 is adjacent to the placement table 111. The second carrier transfer arm 113 is configured to hold and transfer the chip carrier 10 in the second transfer section 112. The second substrate transfer arm 114 is configured to hold and transfer the device substrate W in the second transfer section 112. Each of the second carrier transfer arm 113 and the second substrate transfer arm 114 is configured to be movable in a horizontal direction (both in the X-axis direction and the Y-axis direction) and a vertical direction, and pivotable around a vertical axis.

The first carry-in/out station 110 has a non-illustrated driver configured to move or rotate the second carrier transfer arm 113 and the second substrate transfer arm 114. The second carrier transfer arm 113 and the second substrate transfer arm 114 may be mounted on the same Y-axis slider and moved in the Y-axis direction simultaneously, or may be mounted on different Y-axis sliders and moved in the Y-axis direction independently. When the second carrier transfer arm 113 and the second substrate transfer arm 114 are mounted on the same Y-axis slider, they are stacked on top of each other in the Z-axis direction. When the second carrier transfer arm 113 and the second substrate transfer arm 114 are mounted on different Y-axis sliders, the Y-axis sliders may be arranged with an offset in the Z-axis direction.

The second carrier transfer arm 113 takes out, from the cassette C5, the chip carrier 10 from which the chips CP are yet to be separated, and transfers it to a transition device 115. Also, the second carrier transfer arm 113 takes out, from the transition device 115, the chip carrier 10 from which the chips CP have been separated, and stores it in the cassette C6. The second carrier transfer arm 113 that takes out the chip carrier 10 from the cassette C5 and the second carrier transfer arm 113 that stores the chip carrier 10 in the cassette C6 may be provided separately.

The second substrate transfer arm 114 takes out, from the cassette C7, the device substrate W before being mounted with the chips CP, and transfers it to a transition device 116. Also, the second substrate transfer arm 114 takes out, from the transition device 116, the device substrate W after being mounted with the chips CP, and stores it in the cassette C8. The second substrate transfer arm 114 that takes out the device substrate W from the cassette C7 and the second substrate transfer arm 114 that stores the device substrate W in the cassette C8 may be provided separately.

The first carry-in/out station 110 is equipped with the transition devices 115 and 116. The transition devices 115 and 116 are disposed between the second transfer section 112 of the first carry-in/out station 110 and a first transfer section 122 of the first processing station 120, and is adjacent to both transfer sections 112 and 122. The transition devices 115 and 116 may be stacked in a vertical direction in order to reduce the footprint of the first carry-in/out station 110.

In the transition device 115, the chip carrier 10 before being subjected to the separation of the chips CP is placed. In the transition device 115, the chip carrier 10 after being subjected to the separation of the chips CP may be placed. Furthermore, separate transition devices 115 may be provided for use before and after the separation of the chips CP, respectively, and they may be provided in multiple numbers.

In the transition device 116, the device substrate W before being mounted with the chips CP is placed. In the transition device 116, the device substrate W after being mounted with the chips CP may be placed. Furthermore, separate transition devices 116 may be provided for use before and after the mounting of the chips CP, respectively, and they may be provided in multiple numbers.

The first processing station 120 has the first transfer section 122, a first carrier transfer arm 123, and a first substrate transfer arm 124. The first transfer section 122 extends in the X-axis direction. The first carrier transfer arm 123 is configured to hold and transfer the chip carrier 10 in the first transfer section 122. The first substrate transfer arm 124 is configured to hold and transfer the device substrate W in the first transfer section 122. Each of the first carrier transfer arm 123 and the first substrate transfer arm 124 is configured to be movable in a horizontal direction (both in the X-axis direction and the Y-axis direction) and a vertical direction, and pivotable around a vertical axis.

The first processing station 120 has a non-illustrated driver configured to move or rotate the first carrier transfer arm 123 and the first substrate transfer arm 124. The first carrier transfer arm 123 and the first substrate transfer arm 124 may be mounted on the same X-axis slider and moved in the X-axis direction simultaneously, or may be mounted on different X-axis sliders and moved in the X-axis direction independently. When the first carrier transfer arm 123 and the first substrate transfer arm 124 are mounted on the same X-axis slider, they are stacked on top of each other in the Z-axis direction. When the first carrier transfer arm 123 and the first substrate transfer arm 124 are mounted on different X-axis sliders, on the other hand, the plurality of X-axis sliders are arranged with an offset in the Z-axis direction.

The first carrier transfer arm 123 takes out, from the transition device 115, the chip carrier 10 from which the chips CP are yet to be separated, and transfers it to a chip attaching device 130 via a chip cleaning device 125. Also, the first carrier transfer arm 123 takes out, from the chip attaching device 130, the chip carrier 10 from which the chips CP have been separated, and transfers it to the transition device 115. The first carrier transfer arm 123 that takes out the chip carrier 10 before being subjected to the separation of the chips CP and the first carrier transfer arm 123 that takes out the chip carrier 10 after being subjected to the separation of the chips CP may be provided separately.

The first substrate transfer arm 124 takes out, from the transition device 116, the device substrate W before being mounted with the chips CP, and transfers it to the chip attaching device 130 via a surface modifying device 126 and a substrate cleaning device 127. Also, the first substrate transfer arm 124 takes out, from the chip attaching device 130, the device substrate W after being mounted with the chips CP, and transfers it to the transition device 116. The first substrate transfer arm 124 that transfers the device substrate W before being mounted with the chips CP and the first substrate transfer arm 124 that transfers the device substrate W after being mounted with the chips CP may be provided separately.

The first processing station 120 is equipped with the chip cleaning device 125, the surface modifying device 126, the substrate cleaning device 127, and the chip attaching device 130. The chip cleaning device 125, the surface modifying device 126, the substrate cleaning device 127, and the chip attaching device 130 are adjacent to the first transfer section 122, and are disposed on the positive Y-axis side or negative Y-axis of the first transfer section 122.

The chip cleaning device 125 is configured to clean the plurality of chips CP electrostatically attracted to the chip carrier 10. By attaching the chips CP to the device substrate W after cleaning the chips CP, a foreign matter can be suppressed from being caught therebetween. The chip cleaning device 125 may remove the protective film PF by supplying a cleaning liquid to the chips CP. When the protective film PF is water-soluble, pure water such as DIW (deionized water) is supplied as the cleaning liquid.

The chip cleaning device 125 has, as shown in FIG. 8, for example, a carrier holder 141, a rotational driver 142, a nozzle 143, and a cup 144. The carrier holder 141 is configured to hold the carrier substrate 20 horizontally from below with the front surface 21 of the carrier substrate 20 facing upwards. The rotational driver 142 is configured to rotate the carrier substrate 20 together with the carrier holder 141. The nozzle 143 is configured to supply a cleaning liquid to the plurality of chips CP. The nozzle 143 may be moved in a direction orthogonal to a rotational center line of the carrier holder 141. The cup 144 collects the cleaning liquid. The cleaning liquid collected in the cup 144 is drained from the inside of the cup 144 to the outside thereof by a non-illustrated draining device.

According to the present exemplary embodiment, as shown in FIG. 3, the recess 21b is formed in the net shape, and the attraction portions 21a are arranged in the island shape in the meshes of the recess 21b. With this configuration, when supplying the cleaning liquid to the chip CP, the cleaning liquid can be easily discharged from the recess 21b. The recess 21b is extended to the edge of the front surface 21 of the carrier substrate 20 so that the cleaning liquid can be easily discharged to the outside of the carrier substrate 20. The depth of the recess 21b is uniform in overall, but the recess 21b may become deeper as it goes from the center of the front surface 21 of the carrier substrate 20 toward the edge thereof. In the latter case, the cleaning liquid can be discharged by using gravity.

In addition, the chip cleaning device 125 may have a non-illustrated cleaning head. The cleaning head is a brush or a sponge, and is configured to scrub-clean the plurality of chips CP. The cleaning head may be configured to apply ultrasonic waves to a liquid film formed between the plurality of chips CP. The liquid film is formed when the nozzle 143 supplies the cleaning liquid.

The surface modifying device 126 is configured to plasma-process the main surface Wc of the device substrate W. In the surface modifying device 126, an oxygen gas as a processing gas is excited into plasma to be ionized under a reduced pressure, for example. As the oxygen ions are radiated to the main surface Wc of the device substrate W, the main surface Wc is modified. The processing gas is not limited to the oxygen gas, and may be, by way of example, a nitrogen gas. The surface modifying device 126 may plasma-process the first surface CPc of the chip CP on the chip carrier 10. If the diameter of the chip carrier 10 is the same as the diameter of the device substrate W, the chip CP and the device substrate W can be modified in the same surface modifying device 126. In the case of plasma-processing the chip CP on the chip carrier 10, scale-up of the surface modifying device 126 can be suppressed as compared to a case where the chip CP is plasma-processed on the frame FR, so that the manufacturing cost of the first chip processing system 101 can also be reduced. In addition, the surface modifying device 126 configured to modify the device substrate W and the surface modifying device 126 configured to modify the chip CP may be provided separately, in which case throughput can be improved.

The substrate cleaning device 127 is configured to clean the main surface Wc of the device substrate W. For example, the substrate cleaning device 127 supplies pure water (for example, deionized water) onto the device substrate W while rotating the device substrate W held by a spin chuck. The pure water spreads over the entire main surface Wc by a centrifugal force, so that the main surface Wc is cleaned. The pure water adds OH groups to the previously modified main surface Wc. The device substrate W and the chip CP can be attached together by using hydrogen bonding between the OH groups. The substrate cleaning device 127 may clean the first surface CPc of the chip CP on the chip carrier 10 or may impart OH groups to the first surface CPc of the chip CP. If the diameter of the chip carrier 10 is the same as the diameter of the device substrate W, the chip CP and the device substrate W can be cleaned in the same substrate cleaning device 127. In the case of cleaning the chip CP on the chip carrier 10, scale-up of the substrate cleaning device 127 can be suppressed as compared to the case where the chip C is cleaned on the frame FR, so that the manufacturing cost of the first chip processing system 101 can also be reduced. In addition, the substrate cleaning device 127 configured to clean the device substrate W and the substrate cleaning device 127 configured to clean the chip CP may be provided separately, in which case the throughput can be improved. Instead of the substrate cleaning device 127, the chip cleaning device 125 may be used to clean the chip CP. When modifying or cleaning the chip CP on the frame FR, since the modification or cleaning deteriorates the tape TP, it is necessary to replace the tape TP in order to reuse the frame FR. Meanwhile, when modifying or cleaning the chip CP on the chip carrier 10, since the modification or cleaning does not deteriorate the chip carrier 10, the chip carrier 10 can be reused as it is.

The chip attaching device 130 attaches the chip CP to the device substrate W. Specifically, the chip attaching device 130 separates the chip CP from the chip carrier 10 and mounts the separated chip CP on the device substrate W. The first device Wb of the device substrate W and the second device CPb of the chip CP are electrically connected. As illustrated in **FIG.** 9, the chip attaching device 130 includes, for example, a first carrier holder 131, a substrate holder 132, a pickup device 133, and a mounting device 134.

The first carrier holder 131 is configured to hold the chip carrier 10. The first carrier holder 131 holds the carrier substrate 20 horizontally from below, allowing the front surface 21 of the carrier substrate 20 facing upwards, for example. The first carrier holder 131 is configured to be movable in a horizontal direction (both in the X-axis direction and the Y-axis direction) and rotatable around a vertical axis.

The chip carrier 10 is configured to electrostatically attract the chip CP. In the case of attracting the chip CP electrostatically, the attracting force can be lost by discharging the electric charges. Unlike when the chip CP is fixed with an adhesive, it is not necessary to perform a process of removing the adhesive. Therefore, the workability of the work of transferring the chip CP from the chip carrier 10 to the device substrate W can be improved.

The substrate holder 132 is configured to hold the device substrate W. The substrate holder 132 holds the device substrate W horizontally from below, allowing the main surface Wc of the device substrate W facing upwards, for example. The substrate holder 132 is configured to be movable in a horizontal direction (both in the X-axis direction and the Y-axis direction) and rotatable around a vertical axis.

The pickup device 133 is configured to separate the chip CP from the chip carrier 10 held by the first carrier holder 131. The pickup device 133 has the side holding head 133a configured to hold the side surface CPe of the chip CP and a first head moving mechanism 133b (see **FIG. 6**) configured to move the side holding head 133a. The side holding head 133a is configured to be movable in a horizontal direction (both in the X-axis direction and the Y-axis direction) and a vertical direction, and rotatable around a vertical axis. The side holding head 133a may support not only the side surface CPe of the chip CP but also the bottom surface (second surface CPd) of the chip CP.

The side holding head 133a is configured to hold the side surface CPe of the chip CP. For example, the side holding head 133a has a pair of claws configured to be opened or closed, and holds the chip CP between the pair of claws. Further, the side holding head 133a may be configured to vacuum-attract the side surface CPe of the chip CP.

The side holding head 133a does not hold the first surface CPe of the chip CP, and keeps a gap from the first surface CPc. Accordingly, even if the protective film PF is removed and the first surface CPe is exposed, attachment of particles to the first surface CPe and formation of scratches thereon may be suppressed.

The side holding head 133a is inserted into the recess 21b formed in the front surface 21 of the carrier substrate 20. At this time, the pair of claws is opened so as not to come into contact with the chip CP. Thereafter, the pair of claws is closed and holds the chip CP therebetween.

The side holding head 133a is inserted into the recess 21b, holding the side surface CPe of the chip CP along the entire vertical direction. Accordingly, the side surface CPe of the chip CP can be stably held, so that the chip CP can be suppressed from falling down.

Thereafter, the first head moving mechanism 133b moves the side holding head 133a upwards. The side holding head 133a is pulled out from the recess 21b of the carrier substrate 20. As a result, the chip CP is separated from the chip carrier 10.

Then, the chip CP is moved from the side holding head 133a to an attraction head 134a. The attraction head 134a attracts and holds the second surface CPd of the chip CP. After the chip CP is separated from the chip carrier 10, it is turned upside down and then brought into contact with the device substrate W.

The mounting device 134 mounts the chip CP separated from the chip carrier 10 by the pickup device 133 onto the device substrate W held by the substrate holder 132. The mounting device 134 has the attraction head 134a configured to attract and hold the second surface CPd of the chip CP and a second head moving mechanism 134b (see **FIG. 6**) configured to move the attraction head 134a.

The attraction head 134a is configured to be movable in a horizontal direction (both in the X-axis direction and the Y-axis direction) and a vertical direction, and rotatable around a horizontal axis (that is, turned upside down). The attraction head 134a attracts the chip CP from above and then moves downwards in that state, thereby mounting the chip CP on the main surface Wc of the device substrate W.

Further, although the attraction head 134a of the mounting device 134 directly receives the chip CP from the side holding head 133a of the pickup device 133 in the present exemplary embodiment, the chip CP may be received via a non-illustrated transfer device. The transfer device is configured to transfer the chip CP from the pickup device 133 to the mounting device 134. The transfer device may also turn the chip CP upside down.

The chip attaching device 130 may have the push pin 136. The push pin 136 is inserted into the through hole 50 of the chip carrier 10 and presses the chip CP, thereby facilitating the separation of the chip CP. A communication hole 131a communicating with the through hole 50 of the chip carrier 10 is formed in the first carrier holder 131. The push pin 136 stands by in the communication hole 131a and is inserted from the communication hole 131a into the through hole 50 to press the chip CP. When the push pin 136 presses the chip CP, the pair of claws constituting the side holding head 133a stands by next to the chip CP. After the push pin 136 presses the chip CP, the pair of claws is closed and holds the chip CP therebetween.

The chip attaching device 130 may have the gas supply line 137 instead of the push pin 136, as depicted in **FIG. 10****.** The gas supply line 137 supplies a gas into the through hole 50 of the chip carrier 10 and presses the chip CP with the pressure of the gas, thereby facilitating the separation of the chip CP. The communication hole 131a communicating with the through hole 50 of the chip carrier 10 is formed in the first carrier holder 131. The gas supply line 137 supplies the gas into the through hole 50 through the communication hole 131a.

The gas supply line 137 has a plurality of individual pipelines 137a configured to individually supply the gas to the plurality of through holes 50. Each of the plurality of individual pipelines 137a is provided with an opening/closing valve 137b. When separating the plurality of chips CP individually, the separation of the individual chips CP can be assisted by controlling the plurality of opening/closing valves 137b individually.

The first carrier holder 131 is provided with, by way of example, a first contact terminal 138 and a first attracting force controller 139. The first contact terminal 138 comes into contact with the operation terminal 40 of the chip carrier 10. A plurality of first contact terminals 138 is provided, corresponding to the plurality of operation terminals 40. The first attracting force controller 139 is connected to the operation terminal 40 of the chip carrier 10 via the corresponding first contact terminal 138 provided in the first carrier holder 131. The operation terminal 40 receives a control signal transmitted from the first attracting force controller 139. The first attracting force controller 139 may be provided outside the first carrier holder 131, or may be a part of the first control device 190.

The first attracting force controller 139 controls the attracting force while being connected to the operation terminal 40 of the chip carrier 10. The first attracting force controller 139 controls the electric charges accumulated in the electrode 30. The first attracting force controller 139 performs a control of discharging the electric charges from the electrode 30, thereby implementing a control of eliminating the attracting force.

The first attracting force controller 139 performs a control of eliminating the attracting force for the chip CP to be separated from the chip carrier 10 while maintaining the attracting force for the remaining chips CP. The timing for supplying the electric charges to the electrode 30 may be differ between the attraction portions 21a. Thus, when one chip CP is being separated from the chip carrier 10, the remaining chips CP can be electrostatically attracted to the chip carrier 10, so that the remaining chips CP can be suppressed from falling down due to the contact with the side holding head 133a.

The chip attaching device 130 may be equipped with a first contact position adjuster 135 configured to sequentially bring the plurality of operation terminals 40 into contact with the single first contact terminal 138 by moving the chip carrier 10 relative to the first carrier holder 131, as shown in **FIG. 11A** to **FIG. 11C****.** Thus, it is possible to deal with a plurality of chip carriers 10 with different pitches of the operation terminals 40. Although the first contact position adjuster 135 is configured to move the chip carrier 10 in the present exemplary embodiment, it may move the first carrier holder 131. In addition, although the push pin 136 is inserted into the through hole 50 of the chip carrier 10, the gas supply line 137 may supply a gas into the through hole 50.

In addition, although not shown, the chip array device 230 may have a second contact position adjuster configured to sequentially bring the plurality of operation terminals 40 into contact with the single second contact terminal 238 by moving the chip carrier 10 relative to the second carrier holder 231. Although the second contact position adjuster moves the chip carrier 10 in the present exemplary embodiment, it may be configured to move the second carrier holder 231.

The first control device 190 (see **FIG. 6**) is, for example, a computer, and is equipped with a CPU (Central Processing Unit) 191 and a recording medium 192 such as a memory. The recording medium 192 stores a program for controlling various processes performed in the first chip processing system 101. The first control device 190 controls the operation of the first chip processing system 101 by causing the CPU 191 to execute the program stored in the recording medium 192. A module controller may be provided for each of modules constituting the first chip processing system 101 to control an operation of each module, and a system controller configured to control the plurality of module controllers in overall may be provided. The first control device 190 may be composed of the module controllers and the system controller.

Now, an example of a chip processing method using the first chip processing system 101 will be described. The following chip processing method is performed under the control of the first control device 190.

First, the second carrier transfer arm 113 of the first carry-in/out station 110 takes out, from the cassette C5, the chip carrier 10 before being subjected to the separation of the chips CP, and transfers it to the transition device 115. Then, the first carrier transfer arm 123 of the first processing station 120 takes out, from the transition device 115, the chip carrier 10 before being subjected to the separation of the chips CP, and transfers it to the chip cleaning device 125. Next, the chip cleaning device 125 cleans the plurality of chips CP, thereby removing the protective film PF. Thereafter, the first carrier transfer arm 123 takes out, from the chip cleaning device 125, the chip carrier 10 before being subjected to the separation of the chips CP, and transfers it to the chip attaching device 130. In the meantime, the first carrier transfer arm 123 may transfer the chips CP together with the chip carrier 10 to the surface modifying device 126 and the substrate cleaning device 127. Since OH groups can be imparted to the bonding surface of the chip CP, the chips CP and the device substrate W can be firmly bonded by hydrogen bonding between the OH groups.

In parallel with the above-described processing, the following processing is performed. First, the second substrate transfer arm 114 of the first carry-in/out station 110 takes out, from the cassette C7, the device substrate W before being mounted with the chips CP, and transfers it to the transition device 116. Next, the first substrate transfer arm 124 of the first processing station 120 takes out, from the transition device 116, the device substrate W before being mounted with the chips CP, and transfers it to the surface modifying device 126. Thereafter, the surface modifying device 126 plasma-processes the main surface Wc of the device substrate W. Afterwards, the first substrate transfer arm 124 takes out the device substrate W from the surface modifying device 126, and transfers it to the substrate cleaning device 127. Next, the substrate cleaning device 127 cleans the main surface Wc of the device substrate W. Thereafter, the first substrate transfer arm 124 takes out the device substrate W from the substrate cleaning device 127, and transfers it to the chip attaching device 130.

Next, the chip attaching device 130 separates the chips CP from the chip carrier 10 and mounts the separated chips CP on the device substrate W, thereby manufacturing the chip-attached substrate CW as shown in FIG. 7C. The first device Wb of the device substrate W and the second device CPb of each chip CP are electrically connected.

Thereafter, the first substrate transfer arm 124 takes out, from the chip attaching device 130, the device substrate W on which the chips CP are mounted, and transfers it to the transition device 116. Thereafter, the second substrate transfer arm 114 of the first carry-in/out station 110 takes out, from the transition device 116, the device substrate W on which the chips CP are mounted, and stores it in the cassette C8.

In addition, the first carrier transfer arm 123 takes out, from the chip attaching device 130, the chip carrier 10 from which the chip CP has been separated, and transfers it to the transition device 115. Next, the second carrier transfer arm 113 of the first carry-in/out station 110 takes out, from the transition device 115, the device substrate W from which the chips CP have been separated, and stores it in the cassette C6.

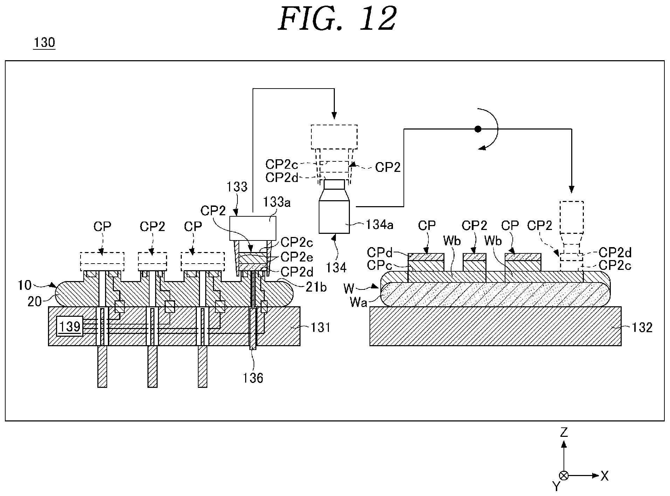

Next, with reference to **FIG. 12****,** a modification example of the chip attaching device 130 will be described. The following description will mainly focus on distinctive features. As shown in **FIG. 12****,** the chip attaching device 130 may attach a plurality of chips CP and CP2 having different functions to the device substrate W. Two chips CP and CP2 are electrically connected to one first device Wb. The two chips CP and CP2 have different devices, *i.e.*, different electric circuits. The first device Wb of the device substrate W is plural in number, and two chips CP and CP2 are electrically connected to each of the plurality of first devices Wb. Furthermore, the number of the chips electrically connected to one first device Wb may be three or more. The three or more chips electrically connected to one first device Wb may have different electric circuits.

The chip attaching device 130 is equipped with, for example, the first carrier holder 131, the substrate holder 132, the pickup device 133, and the mounting device 134. The first carrier holder 131 holds the chip carrier 10. The chip carrier 10 electrostatically attracts and transfers the plurality of chips CP and CP2 having different functions. The plurality of chips CP and CP2 are transferred together with the chip carrier 10.

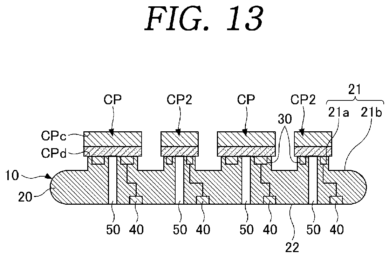

As depicted in **FIG. 13****,** the carrier substrate 20 has the front surface 21 and the rear surface 22 opposite to the front surface 21. The front surface 21 of the carrier substrate 20 has the plurality of attraction portions 21a. The attraction portion 21a configured to electrostatically attract the chip CP and the attraction portion 21a configured to electrostatically attract the chip CP2 may have different dimensions or different shapes. The attraction portion 21a for electrostatically attracting the chip CP2 is formed to be smaller than the chip CP2. When arranging the plurality of chips CP2 on the chip carrier 10, the required level of positioning accuracy for the chip CP2 may be reduced.

The front surface 21 of the carrier substrate 20 has the recess 21b at the periphery of each of the plurality of attraction portions 21a, and the recess 21b is recessed more than the attraction portions 21a. With this configuration, a side surface CP2e of the chip CP2 can be held along the entire vertical direction thereof by the side holding head 133a inserted into the recess 21b, as shown in **FIG. 12****.** Accordingly, the side surface CP2e of the chip CP2 can be stably held, so the chip CP2 can be suppressed from falling down. Furthermore, a bottom surface (second surface CP2d) of the chip CP2 as well as the side surface CP2e thereof may be supported.

As illustrated in **FIG. 12****,** the pickup device 133 has the side holding head 133a. The side holding head 133a configured to hold the side surface CP2e of the chip CP2 and the side holding head 133a configured to hold the side surface CPe of the chip CP may be provided separately, and may have different dimensions or different shapes. The side holding head 133a may be plural in number, and the plurality of side holding heads 133a may be mounted to a single rotary holder and rotated along with the rotary holder. In the configuration where the plurality of side holding heads 133a are provided, there may be performed a control of switching the side holding head 133a to be used depending on the dimension or shape of the chip CP (CP2) involved.

The chip attaching device 130 sequentially separates the plurality of chips CP having the same function one by one from the chip carrier 10, and attaches them to the device substrate W. Thereafter, the chip attaching device 130 sequentially separates the plurality of chips CP2 having another same function one by one from the chip carrier 10, and attaches them to the device substrate W. When switching the side holding head 133a to be used depending on the dimensions or shapes of the chips CP and CP2, the number of switching operations may be reduced.

In addition, although not shown, the pickup device 133 may have an attraction head configured to hold the first surface CPc (CP2c) of the chip CP (CP2) in a non-contact manner. The attraction head is configured to attract the first surface CPc (CP2c) of the chip CP (CP2) while keeping a gap from the chip CP (CP2). The attraction head is of, for example, an ultrasonic type or a Bernoulli type. The ultrasonic type utilizes a squeeze effect due to ultrasonic vibration, and the Bernoulli type utilizes the Bernoulli effect. The ultrasonic type can suppress misalignment in a horizontal direction, as compared to the Bernoulli type.

The mounting device 134 mounts the chip CP (CP2) separated from the chip carrier 10 by the pickup device 133 onto the device substrate W held by the substrate holder 132. The mounting device 134 has the attraction head 134a. The attraction head 134a attracts and holds the second surface CP2d of the chip CP2. The attraction head 134a configured to attract and hold the second surface CP2d of the chip CP2 and the attraction head 134a configured to attract and hold the second surface CPd of the chip CP may be provided separately, and may have different dimensions or different shapes. The attraction head 134a is plural in number, and the plurality of attraction heads 134a may be mounted to a single rotary holder and rotated along with the rotary holder. In the configuration where the plurality of attraction heads 134a are provided, there may be performed a control of switching the attraction head 134a to be used depending on the dimension or shape of the chip CP (CP2) involved.

The chip attaching device 130 sequentially separates the plurality of chips CP having the same function one by one from the chip carrier 10, and attaches them to the device substrate W. Thereafter, the chip attaching device 130 sequentially separates the plurality of chips CP2 having another same function one by one from the chip carrier 10, and attaches them to the device substrate W. When switching the attraction head 134a to be used depending on the dimensions or shapes of the chips CP and CP2, the number of switching operations may be reduced.

As illustrated in **FIG. 12****,** the chips CP and CP2 may be arranged in the same layout when they are electrostatically attracted to the chip carrier 10 and when they are attached to the device substrate W. Since the time taken to separate the chips CP and CP2 from the chip carrier 10 and attach them to the device substrate W (the time taken to manufacture the chip-attached substrate CW) can be made constant, so that the quality of the chip-attached substrate CW can be controlled consistent.

As stated above, the single chip carrier 10 may electrostatically attract and transfer the plurality of chips CP and CP2 having different functions. In this case, the chip array device 230 move the plurality of chips CP and CP2 having the different functions from tapes separately prepared according to the functions of the chips CP and CP2 onto the single chip carrier 10. The chips CP and the chips CP2 are mounted on different frames with the different tapes interposed therebetween, and are moved onto the single chip carrier 10.

In addition, separate chip carriers 10 may be prepared according to the functions of the chips CP and CP2. The chip carrier 10 configured to electrostatically attract the chip CP and the chip carrier 10 configured to electrostatically attract the chip CP2 may be prepared separately, and then sequentially transferred to the chip attaching device 130. In this case as well, the chip attaching device 130 is capable of attaching the plurality of chips CP and CP2 having the different functions to the device substrate W.

Regarding the above-described exemplary embodiment, the following appendix is disclosed.

### [Appended 1]

A chip array device configured to arrange multiple chips on a chip carrier which has, on a front surface thereof, multiple attraction portions each configured to electrostatically attract the multiple chips, comprising:
a second carrier holder configured to hold the chip carrier;
a frame holder configured to hold a frame on which the multiple chips are mounted with a tape therebetween; and
a chip transferer configured to transfer the multiple chips from the tape provided in an opening of the frame held by the frame holder to the chip carrier held by the second carrier holder.

### [Appended 2]

The chip array device described in Appended 1,
wherein the chip has a first surface, and a second surface that is in contact with the tape in an opposite direction to the first surface,
a protective film is formed on the first surface of the chip in advance, and
the chip transferer has a collet configured to hold the chip with the protective film therebetween, and a collet moving mechanism configured to move the collet.

### [Appended 3]

The chip array device described in Appended 1 or 2,
wherein the chip carrier comprises a carrier substrate having the front surface and a rear surface opposite to the front surface; multiple electrodes provided in the carrier substrate to generate an attracting force to electrostatically attract the chip on each of the attraction portions individually; and an operation terminal provided in the carrier substrate to be connected to a second attracting force controller configured to control the attracting force, and
the chip array device further comprises the second attracting force controller.

### [Appended 4]

The chip array device described in Appended 3,
wherein a second contact terminal provided at the second carrier holder to be brought into contact with the operation terminal, and
the second attracting force controller is connected to the operation terminal via the second contact terminal.

### [Appended 5]

The chip array device described in Appended 4,
wherein the operation terminal includes multiple operation terminals, and
the chip array device further comprises a second contact position adjuster configured to move the chip carrier relative to the second carrier holder to sequentially bring the multiple operation terminals into contact with the second contact terminal.

### [Appended 6]

A chip processing method of arranging multiple chips on a chip carrier having, on a front surface thereof, multiple attraction portions each configured to electrostatically attract the chip, comprising:
holding the chip carrier with a second carrier holder;
holding, with a frame holder, a frame mounted with the multiple chips with a tape therebetween; and
transferring the multiple chips from the tape provided in an opening of the frame held by the frame holder to the chip carrier held by the second carrier holder.

So far, the exemplary embodiment of the chip attaching device, the chip processing system and the chip processing method according to the present disclosure have been described. However, the present disclosure is not limited to the above-described exemplary embodiment or the like. Various changes, corrections, replacements, addition, deletion and combinations may be made within the scope of the claims, and all of these are included in the scope of the inventive concept of the present disclosure.

This application claims priority to Japanese Patent Application No. 2022-038103, filed on March 11, 2022, which application is hereby incorporated by reference in their entirety.

### EXPLANATION OF CODES

10: Chip carrier
21: Front surface
21a: Attraction portion
130: Chip attaching device
131: First carrier holder
132: Substrate holder
133: Pickup device
134: Mounting device
CP: Chip
CPb: Second device
CPc: First surface
CPd: Second surface
W: Device substrate
Wb: First device
Wc: Main surface

## Claims

1. A chip attaching device configured to attach a chip having a second device to a device substrate having multiple first devices on a main surface thereof, the second device being to be electrically connected to the first device, the chip attaching device comprising:
a first carrier holder configured to hold a chip carrier which has, on a front surface thereof, multiple attraction portions, the attraction portion being configured to electrostatically attract the chip;
a substrate holder configured to hold the device substrate;
a pickup device configured to separate the chip from the chip carrier held by the first carrier holder; and
a mounting device configured to mount the chip separated from the chip carrier by the pickup device on the device substrate held by the substrate holder.

2. The chip attaching device of Claim 1,
wherein the chip carrier comprises a carrier substrate having the front surface and a rear surface opposite to the front surface; multiple electrodes provided in the carrier substrate to generate an attracting force to electrostatically attract the chip on each of the attraction portions individually; and an operation terminal provided in the carrier substrate to be connected to a first attracting force controller configured to control the attracting force,
the front surface of the carrier substrate has a recess at a periphery of each of the multiple attraction portions, and the recess is recessed more than the attraction portion, and
the pickup device comprises a side holding head configured to be inserted into the recess to hold a side surface of the chip; and a first head moving mechanism configured to move the side holding head.

3. The chip attaching device of Claim 2,
wherein the chip carrier is provided with, in the attraction portion, a through hole formed through the carrier substrate from the front surface to the rear surface, and
the chip attaching device has a push pin configured to be inserted into the through hole to press the chip.

4. The chip attaching device of Claim 2,
wherein the chip carrier is provided with, in the attraction portion, a through hole formed through the carrier substrate from the front surface to the rear surface, and
the chip attaching device has a gas supply line configured to supply a gas into the through hole.

5. The chip attaching device of any one of Claims 2 to 4,
wherein the chip includes multiple chips,
the chip attaching device comprises the first attracting force controller, and
the first attracting force controller performs a control of eliminating the attracting force on the chip to be separated from the chip carrier while maintaining the attracting force on remaining chips.

6. The chip attaching device of any one of Claims 2 to 4, further comprising:
a first contact terminal provided at the first carrier holder to be brought into contact with the operation terminal of the chip carrier, and
the first attracting force controller is connected to the operation terminal via the first contact terminal.

7. The chip attaching device of Claim 6,
wherein the operation terminal includes multiple operation terminals, and
the chip attaching device further comprises a first contact position adjuster configured to move the chip carrier relative to the first carrier holder to sequentially bring the multiple operation terminals into contact with the first contact terminal.

8. A chip processing system, comprising:
a chip attaching device as claimed in any one of Claims 1 to 4;
a chip cleaning device configured to remove a protective film previously formed on the chip electrostatically attracted to the chip carrier;
a first transfer section adjacent to the chip attaching device and the chip cleaning device; and
a first carrier transfer arm configured to transfer the chip carrier in the first transfer section,
wherein the first carrier transfer arm transfers the chip carrier from the chip cleaning device to the chip attaching device.

9. A chip processing system, comprising:
a chip attaching device as claimed in any one of Claims 1 to 4;
a surface modifying device configured to plasma-process the main surface of the device substrate;
a substrate cleaning device configured to supply water to the plasma-processed main surface;
a first transfer section adjacent to the chip attaching device, the surface modifying device, and the substrate cleaning device; and
a first substrate transfer arm configured to transfer the device substrate in the first transfer section,
wherein the first substrate transfer arm transfers the device substrate to the surface modifying device, the surface cleaning device, and the chip attaching device in this order.

10. A chip processing method, comprising:
attaching a chip having a second device to a device substrate having multiple first devices on a main surface thereof, the second device being to be electrically connected to the first device,
wherein the attaching of the chip to the device substrate comprises:
holding, with a first carrier holder, a chip carrier having, on a front surface thereof, multiple attraction portions, the attraction portion being configured to electrostatically attract the chip;
holding the device substrate with a substrate holder;
separating the chip from the chip carrier held by the first carrier holder; and
mounting the chip separated from the chip carrier on the device substrate held by the substrate holder.

11. The chip processing method of Claim 10,
wherein the chip carrier comprises a carrier substrate having the front surface and a rear surface opposite to the front surface; multiple electrodes provided in the carrier substrate to generate an attracting force to electrostatically attract the chip for each of the attraction portions individually; and an operation terminal provided in the carrier substrate to be connected to a first attracting force controller configured to control the attracting force,
the front surface of the carrier substrate has a recess provided at a periphery of each of the multiple attraction portions, and the recess is recessed more than the attraction portion, and
the separating of the chip from the chip carrier comprises:
inserting a side holding head, which is configured to hold a side surface of the chip, into the recess of the front surface of the carrier substrate so as not to be in contact with the chip;
holding the side surface of the chip with the side holding head inserted into the recess; and
lifting the side holding head from the recess.

12. The chip processing method of Claim 11,
wherein a through hole formed through the carrier substrate from the front surface to the rear surface is formed in the attraction portion, and
the separating of the chip from the chip carrier comprises inserting a push pin into the through hole to press the chip with the push pin.

13. The chip processing method of Claim 11,
wherein a through hole formed through the carrier substrate from the front surface to the rear surface is formed in the attraction portion, and
the separating of the chip from the chip carrier comprises supplying a gas into the through hole to press the chip with a pressure of the gas.

14. The chip processing method of any one of Claims 11 to 13,
wherein the chip includes multiple chips,
the separating of the chip from the chip carrier comprises:
eliminating, by the first attracting force controller, the attracting force of the chip to be separated from the chip carrier while maintaining the attracting force of remaining chips.

15. The chip processing method of any one of Claims 11 to 13, further comprising:
bringing a first contact terminal provided at the first carrier holder into contact with the operation terminal of the chip carrier to connect the operation terminal to the first attracting force controller via the first contact terminal.

16. The chip processing method of Claim 15,
wherein the operation terminal includes multiple operation terminals, and
the chip processing method further comprises moving the chip carrier relative to the first carrier holder to sequentially bring the multiple operation terminals into contact with the first contact terminal.

17. The chip processing method of any one of Claims 10 to 13, further comprising:
removing, before attaching the chip to the device substrate, a protective film previously formed on the chip electrostatically attracted to the chip carrier.

18. The chip processing method of any one of Claims 10 to 13, further comprising:
plasma-processing the main surface of the device substrate before attaching the chip to the device substrate; and
supplying water to the plasma-processed main surface before attaching the chip to the device substrate.

19. The chip processing method of any one of Claims 10 to 13,
wherein the chip includes multiple chips,
the chip processing method further comprises arranging, before attaching the chip to the device substrate, the multiple chips on the chip carrier, and
the arranging of the multiple chips comprises:
holding the chip carrier with a second carrier holder;
holding, with a frame holder, a frame mounted with the multiple chips with a tape therebetween; and
transferring the multiple chips from the tape provided in an opening of the frame held by the frame holder to the chip carrier held by the second carrier holder.
